Europäisches Patentamt

(19) European Patent Office

Office européen des brevets

(11) Publication number : **0 030 116 B2**

(12) # NEW EUROPEAN PATENT SPECIFICATION

(45) Date of publication of the new patent specification : **22.04.92 Bulletin 92/17**

(51) Int. Cl.⁵ : **H01L 21/90, H01L 21/31, H01L 21/00**

(21) Application number : **80304232.4**

(22) Date of filing : **26.11.80**

(54) **Method of manufacturing a semiconductor device having a patterned multi-layer structure.**

(30) Priority : **28.11.79 JP 154003/79**

(43) Date of publication of application :
**10.06.81 Bulletin 81/23**

(45) Publication of the grant of the patent :
**19.08.87 Bulletin 87/34**

(45) Mention of the opposition decision :
**22.04.92 Bulletin 92/17**

(84) Designated Contracting States :
**DE FR GB**

(56) References cited :
**EP-A- 0 015 403
DE-A- 2 340 442
DE-A- 2 727 788
DE-A- 2 730 156
DE-A- 2 845 460
DE-C- 2 632 093
JP-A- 5 240 978
IBM TECHNICAL DISCLOSURE BULLETIN,
vol. 20, no. 4, September 1977, page 1388, New
York, US; T.A. BARTUSH et al.: "Sidewall
tailoring using two different reactive ion
etchants in succession"
EXTENDED ABSTRACTS OF THE JOURNAL
OF THE ELECTROCHEMICAL SOCIETY, vol.
77-2, October 1977, pages 400,401, abstract
no. 145, Princeton, US; E.C.D. DAWALL: "The
control of plasma etched edge profiles"
EXTENDED ABSTRACTS OF THE JOURNAL
OF THE ELECTROCHEMICAL SOCIETY, vol.
79-2, 14th-19th October 1979, pages 1524-1526,
abstract no. 608, Princeton, US; R.A. GDULA:
"SF6 rie of polysilicon"
IBM TECHNICAL DISCLOSURE BULLETIN,
vol. 15, no. 5, October 1972, page 1620, New
York, US; R.C. TURNBULL: "Tapering metal-
lurgy edges"
SOLID-STATE TECHNOLOGY, vol. 21, no. 4,
April 1978, pages 117-121, Washington, US;
R.L. BERSIN: "Chemically selective, anisot-
ropic plasma etching"
SOLID-STATE TECHNOLOGY, vol. 22, no. 4,
April 1979, pages 125-132, Washington, US;
P.D. PARRY et al.: "Anisotropic plasma etch-
ing of semiconductor materials"**

(56) References cited :
**JOURNAL OF THE ELECTROCHEMICAL SOCI-
ETY, vol. 126, no. 3, March 1979, pages
504-506, Princeton, US; H. ONO et al.: "A new
technology for tapered windows in insulating
films"
EXTENDED ABSTRACTS OF THE JOURNAL
OF THE ELECTROCHEMICAL SOCIETY, no. 2,
October 1978, pages 515-517, abstract no. 193,
Princeton, US; R.A. PORTER et al.: "Plasma
etching of phosphosilicate glass"
EXTENDED ABSTRACTS OF THE JOURNAL
OF THE ELECTROCHEMICAL SOCIETY, no. 2,
October 1978, pages 509-511, abstract no. 191,
Princeton, US; W.R. HARSHBARGER et al.:
"Plasma assisted etching for VLSI"
IBM Technical Disclosure Bulletin, (1977, 02),
pp 3415-3416
Electronics (1978, 08.31), pp 117-121
IEEE Tr. ED-25 (1978.10) pp. 1178-1185
IBM Technical Disclosure Bulletin (1979.12)
pp.2737-38**

(73) Proprietor : **FUJITSU LIMITED
1015, Kamikodanaka Nakahara-ku
Kawasaki-shi Kanagawa 211 (JP)**

(72) Inventor : **Sugishima, Kenji
896-2-309, Kamikodanaka Nakahara-ku
Kawasaki-shi Kanagawa 211 (JP)**
Inventor : **Takada, Tadakazu
185-11-106, Taira Takatsu-ku
Kawasaki-shi Kanagawa 213 (JP)**

(74) Representative : **Bedggood, Guy Stuart et al
Haseltine Lake & Co. Hazlitt House 28
Southampton Buildings Chancery Lane
London WC2A 1AT (GB)**

EP 0 030 116 B2

## Description

The present invention relates to a method of manufacturing a semiconductor device.

In the manufacture of semiconductor devices, which is being developed and improved continuously, photolithographic processes for patterning a substrate surface are fundamentally important. As is generally understood, conventional wet etching techniques using chemicals appear to have reached a limit of their precision, and extremely minute patterns are now formed by means of dry etching instead. However, very sharp edges or steps are produced by dry etching as presently practiced.

These days, the technology for the manufacture of integrated circuits is under review for the purpose of increasing integrated circuit packing density so that the characteristics of integrated circuits may be improved, for example to provide faster speed of operation, lower dissipation of power and so forth. While patterns formed on a substrate surface have tended to become finely miniaturised, there is a new trend towards the fabrication of integrated circuit with multi-layer structures.

As the number of layers increases from three to four, for example, steps or differences between levels of adjacent layers increase, and this results in differences of thickness of layers grown on top of other layers, for example wiring layers and insulation layers. If a wiring layer is formed in such a way that it is very thin at steps in an underlying layer, a break in the wiring layer is likely to appear, and if an insulation layer is formed in -such a way that it is very thin at steps in an underlying layer, a wiring layer over the insulation layer may easily be short-circuited.

Compared to dry etching conventional wet etching, which could not produce such fine patterns, has proved to be advantageous from the point of view of problems resulting from formation of sharp steps.

In order to produce a finely patterned wiring layer for example, dry etching as practiced recently becomes necessary. For avoiding steps or edges with sharp corners where a wiring or insulation layer is etched or cut through, conventional wet etching has been found to be advantageous. To obtain tapered or inclined sides for a wiring or insulation layer contradicts the purpose of forming fine patterns. Yet, in the fabrication of densely packed integrated circuits, these two qualities must be provided simultaneously.

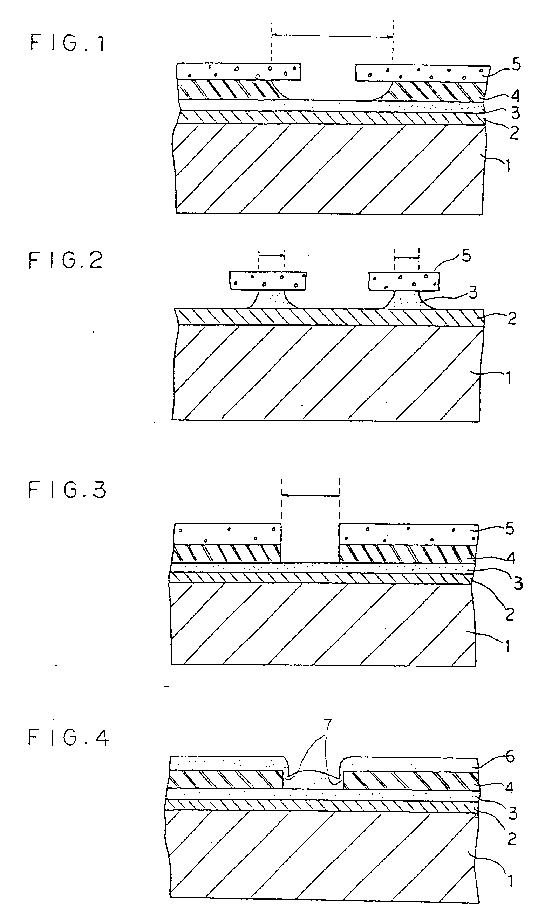

The formation of fine patterns has been partially accomplished by miniaturisation of windows for electrodes and via holes (through holes) formed through an insulation layer on a semiconductor substrate. Referring to Figure 1 of the accompanying drawings which schematically illustrates in cross-section a through or via hole formed by an isotropic etching process carried out by means of a conventional wet etching or a barrel type etching device, a via hole through an insulation layer 4, of phospho-silicate glass (PSG) for example, reaching through to a wiring layer 3 of aluminium or poly crystal silicon formed on an insulation layer 2 grown on a semiconductor (silicon) substrate 1 has an opening which is larger than that in a photoresist layer or film 5 used as a mask in formation of the hole. This indicates that an accurate and fine via hole cannot be formed by such a conventional isotropic etching technique.

A similar problem is also experienced when forming wiring patterns by conventional isotropic etching. Figure 2 of the accompanying drawings illustrates schematically and in cross-section wiring patterns 3 formed on an insulating layer 2 grown on a semiconductor (silicon) substrate 1 by conventional isotropic etching using a photoresist layer or film 5 as a mask. The width of the upper surfaces of the wiring layer 3 parts is smaller than the width of the photoresist film 5 parts used as a mask, although it was expected that the former should be equal to the latter.

In order to overcome these problems, a planar type plasma etching device has been selected for use to avoid side etchings inevitable in isotropic etching. If a via hole is etched into the structure of Figure 1 using such a planar type plasma etching device, the insulation layer 4 of PSG is etched in a direction vertical to the surface of the substrate 1 as shown in Figure 3 of the accompanying drawings, which is a schematic cross-sectional view. The opening of the via hole thus formed is substantially equal to the opening of the photoresist film 5 used as a mask.

However, with a via hole formed by planar type plasma etching, when the photoresist film 5 is removed and wiring 6, of aluminium for example, patterned on the insulation layer 4, the wiring 6 covers the insulation layer 4 only thinly at those places indicated by reference numeral 7 in Figure 4 of the accompanying drawings, which is also a schematic cross-sectional view, because edges of the via hole are sharp.

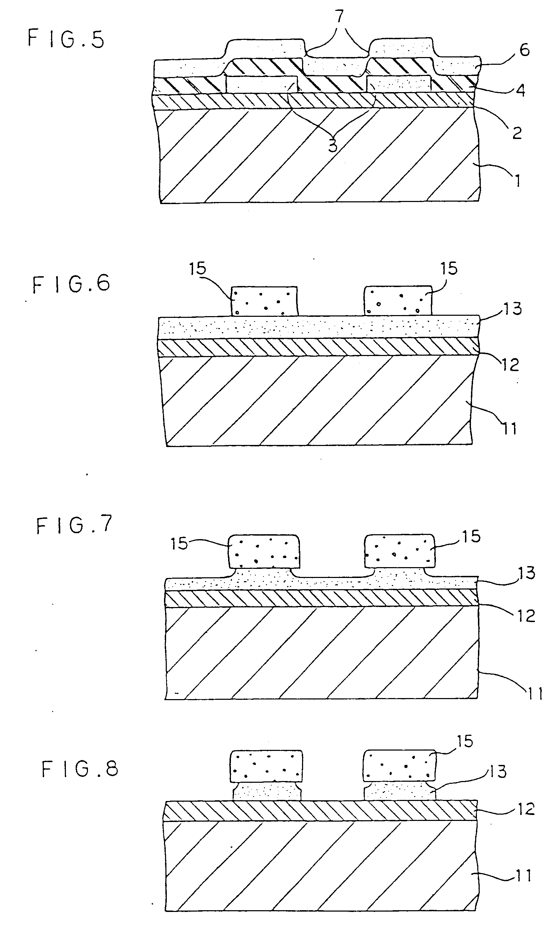

Figure 5 of the accompanying drawings illustrates schematically in cross-section two wiring layers fabricated in accordance with a conventional technique. In the illustrated arrangement of wiring layers, in which wiring layer 3 is formed on insulation layer 2, employing a planar type plasma etching device, and a wiring layer 6 is patterned on insulation layer 4, the wiring layer 6 may be broken at step 7. This is due to sharp or sudden steps formed by anisotropic dry etching carried out when wiring layers 3 were patterned.

Accordingly to the present invention there is provided a method of manufacturing a semiconductor device in accordance with claim 1.

The present invention provides a method of forming minute and fine patterns by a sequence of etchings, which avoids problems encountered in conventional etchings.

An embodiment of the present invention provides a method of forming accurately a window for an electrode or a via hole of very small size, for example, which comprises the following steps: a first insulation layer of silicon dioxide ($SiO_2$) for example is formed on a semiconductor substrate, a wiring layer of aluminium is formed on the first insulation layer, and another (second) insulation layer, of phospho-silicate glass (PSG) for example, is formed on the wiring layer. A thin film of positive photoresist to be used as a mask is formed on the second insulation layer. A window is cut through the thin film by known means to prepare for etching of the PSG insulation layer using the thin film of photoresist as a mask. Firstly, an isotropic etching is effected to etch through a part of, e.g. about one half the depth of, the PSG insulation layer, then an anisotropic etching is carried out in the direction of the depth of the PSG layer, that is in a direction perpendicular to the plane of the substrate, until the aluminium wiring layer under the PSG layer is exposed.

The isotropic etching and the anisotropic etching may both be carried out by means of a planar type plasma etching device.

An embodiment of the present invention provides a process wherein two conflicting ends (the formation of minute patterns and the avoidance of defects found in the prior art) are attained by producing tapering or inclined sides in an etched layer by a combination of isotropic etching and anisotropic etching.

The method of the present invention may be applied to any materials that may be etched away by any known etching techniques.

There may be as many layers as are required, and if both isotropic etching and anisotropic etching are carried out by dry etching, both dry etchings may be carried out in the same apparatus. This can be provided by properly selecting reactive gases and conditions for dry etching such as the amount of reactive gas, the gas pressure and applied radio frequency power.

The present invention provides a general method for the patterning of a layer on a semiconductor substrate comprising the steps of forming a thin film having a predetermined pattern on a layer to be etched, etching the layer partly by an isotropic etching using the thin film as a mask, then etching the layer in the direction of its depth by an anisotropic etching until an underlying layer appears. The sides of the layer etched have a tapered or inclined configuration. It will be understood that an isotropic etching may be effected by a wet etching or a dry etching, and an anisotropic etching can only be realised by a dry etching.

The present invention also provides a method wherein the isotropic and anisotropic etchings are carried out in the same apparatus by properly selecting reactive gases and conditions for dry etching, such as the amount of gas, gas pressure and applied radio frequency power.

Reference is made, by way of example, to the accompanying drawings, in which:-

Figure 1, as mentioned above, is a cross-sectional schematic view of a semiconductor device structure according to the prior art in which an insulation layer on a wiring layer formed on an insulation film grown on a semiconductor substrate has been etched by an isotropic etching;

Figure 2, as mentioned above, is a cross-sectional schematic view of wiring layers etched by an isotropic etching according to the prior art;

Figure 3, as mentioned above, is a schematic view in cross-section of a structure similar to that shown in Figure 1, but showing an insulation layer etched by an anisotropic etching;

Figure 4, as mentioned above, is a cross-sectional schematic view of a wiring layer formed on the insulation layer shown in Figure 3;

Figure 5, as mentioned above, is a view similar to Figure 4, but showing wiring layers formed after an anisotropic etching and on which are formed an insulation layer and another wiring layer,

Figures 6 to 8 inclusive are respective cross-sectional schematic views illustrating steps in a method embodying the present invention;

Figure 9 is a cross-sectional schematic view illustrating manufacturing steps following the steps of Figures 6 to 8;

Figure 10 is a cross-sectional schematic view illustrating further embodiments of the present invention; and

Figures 11 and 12 are cross-sectional schematic views of a planar type plasma etching device and a reactive sputter etching device respectively.

When patterning a film or layer formed (directly or indirectly) on a semiconductor substrate according to a method embodying the present invention, etching of the layer is partly effected by an isotropic etchingp then an anisotropic etching is carried out until the patterning is complete.

Isotropic etching may be effected by means of a wet etching process or a dry etching process, whilst anisotropic etching in the direction of the depth of the film or layer, or in a direction perpendicular to the surface of the semiconductor substrate, can only be realzed by a dry etching process.

Thus, in order to carry out embodiments of the present invention, possible combinations of different etching

3

processes are as follows:-

| Isotropic etching | Anisotropic etching |
| --- | --- |
| (a) wet etching | dry etching (planar type) |
| (b) dry etching (barrel type) | dry etching (planar type) |
| (c) dry etching (planar type) | dry etching (planar type) |

Any of these combinations may be selected to meet various requirements as will be described hereinafter.

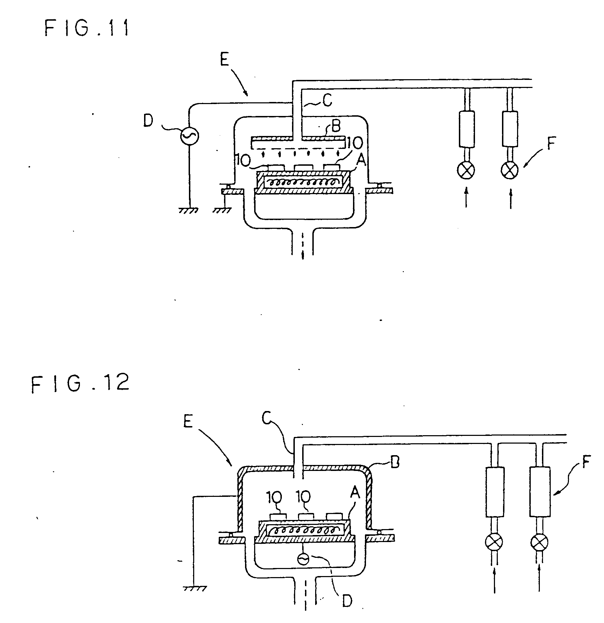

In Figure 11 and 12, there are shown schematically and in cross-section a planar type plasma etching device E and a reactive sputter etching device or a reactive ion etching device E respectively. In each of these devices, semiconductor substrates 10 are placed on an electrode A. Radio frequency power, at a frequency of 13.56 MHz for example, generated by a power source D is applied between the electrode A and an oppositely arranged electrode B. Reactive gas supplied from F (control tap and flow meter) is introduced into device E through an inlet C, and is turned into plasma by the applied r.f. power, and substrates 10 are etched.

A method embodying the present invention will now be explained with reference to Figures 6 to 8 inclusive which show schematically in cross-section structures produced in the steps involved in the embodiment.

Figure 6 shows a poly crystal silicon layer 13, thickness 500 nm (5,000Å), which has been grown on an insulation layer 12 of silicon dioxide, for example, that has already been grown on a semiconductor substrate 11. The layer 13 is coated with a thin film 15 of positive photographic emulsion, or photoresist, by a spinning and baking process, the film 15 being shown in a condition after patterning thereof. Using the film 15 as a mask, an isotropic etching is carried out until a thickness of 250 nm (2,500 Å) has been etched away from the layer 13 of poly crystal silicon (Figure 7). In this embodiment, $CF_4$ gas mixed with 5% $O_2$ is selected as reactive gas, and etching conditions were as follows:- radio frequency power 1 KW, gas pressure 133.3 Pa (1 Torr), and etching time 2.5 minutes. In this isotropic etching, side etchings progress sideways as shown in Figure 7, and an opening formed in the upper part of poly crystal silicon layer 13 is larger than the corresponding opening in the resist film 15.

It was also found that one alternative to the reactive gas and etching conditions mentioned above is the use of $CF_4$ gas mixed with $C_2F_5Cl$, instead of 5% $O_2$, and by maintaining the gas pressure at 266.6 Pa (2 Torr), the thickness of 250 nm (2,500 Å) was etched away from the layer 13 in 20 seconds using the same radio frequency power.

Next, in the same apparatus, an anisotropic etching is carried out to etch away the remaining thickness of 250 nm (2,500 Å) of the layer 13 (Figure 8). In this embodiment the selected reactive gas is $CCl_4$, and the etching conditions are as follows:- r.f. power 1 KW, gas pressure 26.7 Pa (0.2 Torr) and etching time 30 seconds. Vertically cut down sides separated by the same distance as the opening in the resist mask (film 15) are produced by this etching. (Figure 8, and combination (c) mentioned above).

The remaining thickness of 250 nm (2,500 Å) of layer 13 may alternatively be etched away by anisotropic etching under any of the conditions as follows: (r.f. power applied, 1 KW in each case).

| Kind of gas | Gas pressure | Etching time |
| --- | --- | --- |
| $CCl_4$ | 26.7 Pa (0.2 Torr) | 30 seconds |
| $CF_4 + C_2F_5Cl$ | 133.3 Pa (1 Torr) | 20 seconds |
| $CF_4 + O_2$ (5%) | 13.3 Pa (0.1 Torr) | 5 minutes |
| $PCl_3$ | 26.7 Pa (0.2 Torr) | 40 seconds |

Thus, in the described embodiment, an isotropic etching is carried out in one apparatus, and in this same apparatus, an anisotropic etching is subsequently effected. A minutely fine pattern wherein side walls are tapered or inclined as shown in Figure 8 is produced as a result.

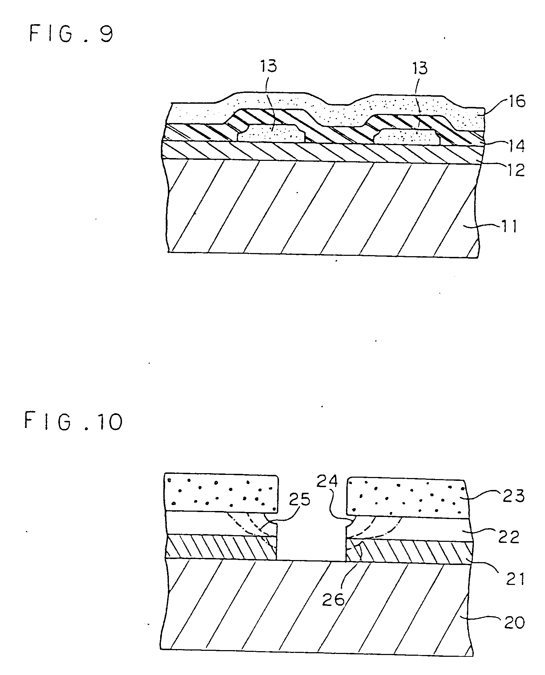

Thereafter, the resist film 15 used as a mask is washed away or removed by an organic solvent, and an insulation layer 14 of PSG for example is grown over the entire surface thus exposed, as shown in Figure 9. The layer 14 and a wiring layer 16 formed thereon have substantially uniform thicknesses respectively devoid of parts which cover only thinly the underlying layer or film.

The kind of gases selected for use play an important role in etchings, for example as carried out in apparatus as shown.

In the tables below various possibilities which can be employed for etching various materials in embodiments of the present invention are given. The tables give information relating to isotropic etching processes and anisotropic etching processes which can be employed in embodiments of the invention.

TABLE 1-1
Isotropic etching—Wet etching

| Material to be etched | Etchant |
|---|---|
| S-Si, Poly Si | $HF—NHO_3$ family |
| CVD $SiO_2$, TG $SiO_2$ | $HF—H_2O$ family |
| PSG | $HF—H_2O$ family |
| Al | $H_3PO_4—HNO_3$ family |

TABLE 1-2
Isotropic etching—Barrel type
plasma etching

| Material to be etched | Etchant |
|---|---|
| S—Si, Poly Si | $CF_4$, $CF_4+O_2$, $CF_3Cl+O_2$ |
| CVD $SiO_2$, TG $SiO_2$ | $CF_4$, $CF_4+O_2$, $CF_3Cl+O_2$ |
| $Si_3N_4$ | $CF_4$, $CF_4+O_2$, $SiF_4$ |
| PSG | $CF_4$, $CF_4+O_2$, $CClF_3+O_2$ |

TABLE 1-3
Isotropic etching—Planar type
plasma etching

| Material to be etched | Etchant |
|---|---|
| S—Si, Poly Si | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |
| CVD $SiO_2$, TG $SiO_2$ | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |
| $Si_3N_4$ | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |
| PSG | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |

TABLE 1-4
Isotropic etching—Reactive ion
etching and reactive sputter etching

| Material to be etched | Etchant |
|---|---|
| S—Si, Poly Si | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |
| CVD $SiO_2$, TG $SiO_2$ | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |
| $Si_3N_4$ | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |
| PSG | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |

TABLE 2-1
Anisotropic etching—Planar type
plasma etching

| Material to be etched | Etchant |
|---|---|
| $Si_3N_4$, S—Si, Poly Si | $CCl_4$, $PCl_3$, $BCl_3$, $SiCl_4$ other chloride compound gases, above chloride compound gases with $O_2$ or $CF_4$, mixed gases with any of above chloride compound gases, mixed gases with any of above chloride compound gases with $O_2$ or $CF_4$; $CF_6$; $CF_4$ or $CF_4+O_2$ (gas pressure below 13.3—26.7 Pa (0.1—0.2 Torr)), $C_2F_5Cl$ or $C_2F_5Cl+CF_4$ (gas pressure 133.3 Pa (1 Torr) or less) |
| PSG, $Si_3N_4$, CVD $SiO_2$, TG $SiO_2$ | $CF_4$ or $CF_4+O_2$ (gas pressure below 13.3—26.7 Pa (0.1—0.2 Torr)), $CF_4+H_2$, $CHF_3$, $C_2F_6$, $C_3F_8$, $C_4F_8$ |
| Al, Al-Cu Al-Si, Al-Cu-Si | $CCl_4$, $PCl_3$, $BCl_3$, other chloride compound gases, mixed gases with any of above chloride compound gases, mixed gases with any of above chloride compound gases with $O_2$ or $CF_4$, mixed gases with any of above chloride compound gases with inactive gas such as Ar, He, etc. |

TABLE 2-2
Anisotropic etching—Reactive ion
etching and reactive sputter etching

| Material to be etched | Etchant |
| --- | --- |
| $Si_3N_4$, S-Si, Poly Si | $CCl_4$, $PCl_3$, $BCl_3$, $SiCl_4$ other chloride compound gases, above chloride compound gases with $O_2$ or $CF_4$, mixed gases with any of above chloride compound gases, mixed gases with any of above chloride compound gases with $O_2$ or $CF_4$; $CF_6$; $CF_4$ or $CF_4+O_2$ (gas pressure below 1.3—2.7 Pa (0.01—0.02 Torr)) $C_2F_5Cl$ or $C_2F_5Cl+CF_4$ (gas pressure 13.3 Pa (0.1 Torr) or less) |
| PSG, $Si_3N_4$, CVD $SiO_2$, TG $SiO_2$ | $CF_4$ or $CF_4+O_2$ (gas pressure below 1.3—2.7 Pa (0.01—0.02 Torr)), $CF_4+H_2$, $CHF_3$, $C_2F_6$, $C_3F_8$, $C_4F_8$ |
| Al, Al-Cu Al-Si, Al-Cu-Si | $CCl_4$, $PCl_3$, $BCl_3$, other chloride compound gases, mixed gases with any of above chloride compound gases, mixed gases with any of above chloride compound gases with $O_2$ or $CF_4$, mixed gases with any of above chloride compound gases with inactive gas such as Ar, He, etc. |

In Tables 1-1 to 2-2, the abbreviations used have the following significance.

| S-Si | single crystal silicon |
| --- | --- |
| Poly Si | poly crystal silicon |
| CVD | chemical vapour deposition |
| TG | thermally grown |
| PSG | phospho-silicate glass |

In the embodiments described with reference to Figures 6 to 9, poly crystal silicon was etched. However, as will be understood from the tables above, layers or films of thermally grown silicon dioxide, silicon dioxide formed by chemical vapour deposition, phospho-silicate glass (PSG) or single crystal silicon may similarly be etched merely by changing etching times, and therefore the invention is not limited to the use of poly crystal silicon alone.

Also with materials other than poly crystal silicon, both isotropic and anisotropic etchings may be carried out in the same apparatus by selecting suitable gas and etching conditions as will be understood from the above Tables 1-3 and 2-1 for example.

For example, referring to Figure 10 which illustrates another embodiment of the invention, a layer 21 of $SiO_2$ is grown on a layer 20 already formed. Another layer 22 of $Si_3N_4$ is formed on the layer 21, and a photoresist film 23 to be used as a mask is formed and patterned on the layer 22. It is desired that the opening of a hole through the composite layer comprising layers 21 and 22 where that hole is in contact with layer 20 be equal to the corresponding opening formed in the resist mask 23. At the same time, in order to avoid formation of steps as seen in Figure 3, it is desired that the sides of the hole in the structures be tapered or inclined as seen in Figure 9.

There are three modes of attaining the desired object. The first is to etch $Si_3N_4$ layer 22 partly as shown by continuous line 24 in Figure 10. The second mode is to etch away $Si_3N_4$ layer 22 completely as shown by the broken line 25. The third is not only to etch away $Si_3N_4$ layer 22 completely, but also to etch $SiO_2$ layer 21 partly as shown by chain line 26.

In each mode, an isotropic etching is carried out in a planar type plasma etching device using a mixed gas of $CF_4+O_2$ for example (see Table 1-3). This is followed by an anisotropic etching using $CF_4$ gas under a pressure of 13.3 Pa (0.1 Torr) or less (see Table 2-1). Care must be taken in the third mode mentioned above in that the etching rate of the material that is etched first must be larger than that of the material that will be etched later. Otherwise, the first material ($Si_3N_4$ in Figure 10) will hang over the second material ($SiO_2$).

Where the material to be etched is aluminium, isotropic and anisotropic etchings cannot at present be carried out in one and the same apparatus (see Tables 1-1 and 2-1 ). With an aluminium film or layer, an isotropic etching is first carried out by a wet etching process because a dry etching process cannot be used at present. This isotropic etching is followed by an anisotropic etching in a planar type plasma etching apparatus, using a chloride compound gas such as $CCl_4$, $PCl_3$ or $BCl_3$, or a mixture of these, or such a mixture mixed with $O_2$ or

$CF_4$, or such a mixture mixed with inactive gas such as argon, helium and the like. This applies also to the etching of aluminium alloys such as Al-Cu, Al-Si, or Al-Cu-Si. (This corresponds to combination (a) mentioned above).

It will be understood that the process of dry etching suitable for formation of fine patterns employed in a method according to the invention which also enables tapered or inclined patterns to be formed such as to prevent breaking down and short-circuiting of wiring layers, to offer a substantial contribution towards improving reliability of semiconductor devices such as integrated circuits.

Thus, an embodiment of this invention provides a method of manufacturing a semiconductor device having a multi-layer structure, which method comprises the steps of patterning, in accordance with a predetermined pattern, a thin film of photoresist formed on a film to be etched which has been formed (directly or indirectly i.e. with intervening layers) on a semiconductor substrate, etching the film to be etched partly through by isotropic etching using the patterned film as a mask, then etching the film to be etched completely through by an anisotropic etching in the direction of its depth, and forming in the etched film a pattern having tapered or inclined sides. The isotropic and anisotropic etchings may be carried out in the same apparatus by changing reactive gases employed for etching and changing etching conditions such as the amount of gas, gas pressure and radio frequency power to be applied.

## Claims

1. A method of manufacturing a semiconductor device having a multi-layer structure, in which a first layer is formed to a predetermined pattern over a second layer, which second layer is to be etched and is formed above a semiconductor substrate of the device, and the second layer is etched through using the first layer as a mask, characterised in that the second layer is etched part way through by isotropic etching, and then the remainder of the second layer is etched through by anisotropic etching in the direction of thickness of the second layer, using the first layer as a mask, to form an overning therethrough, the first layer is then removed and a third layer is formed on the second layer.

2. A method according to claim 1 wherein said third layer is an insulating layer.

3. A method according to claim 2 wherein a conductive layer is formed a said third layer.

4. A method as claimed in claim 1, wherein the second layer is of a material listed in Tables 1-1 to 2-2 hereunder, the isotropic etching employs an etchant (and etching conditions) indicated as appropriate to that material in any one of Tables 1-1 to 1-4, and the anisotropic etching employs an etchant (and etching conditions) indicated as appropriate to that material in any one of Tables 2-1 and 2-2.

TABLE 1-1
Isotropic etching—Wet etching

| Material to be etched | Etchant |
|---|---|
| S-Si, Poly Si | $HF-HNO_3$ family |
| CVD $SiO_2$, TG $SiO_2$ | $HF-H_2O$ family |
| PSG | $HF-H_2O$ family |
| Al | $H_3PO_4-HNO_3$ family |

TABLE 1-2
Isotropic etching—Barrel type
plasma etching

| Material to be etched | Etchant |
|---|---|
| S-Si, Poly Si | $CF_4$, $CF_4+O_2$, $CF_3Cl+O_2$ |
| CVD $SiO_2$, TG $SiO_2$ | $CF_4$, $CF_4+O_2$, $CF_3Cl+O_2$ |
| $Si_3N_4$ | $CF_4$, $CF_4+O_2$, $SiF_4$ |
| PSG | $CF_4$, $CF_4+O_2$, $CClF_3+O_2$ |

TABLE 1-3
Isotropic etching—Planar type
plasma etching

| Material to be etched | Etchant |
|---|---|
| S-Si, Poly Si | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |
| CVD $SiO_2$, TG $SiO_2$ | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |
| $Si_3N_4$ | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |
| PSG | $C_2F_5Cl+CF_4$ (gas pressure 133.3 Pa (1 Torr) or more) $CF_4$ or $CF_4+O_2$ (gas pressure of 13.3—26.7 Pa (0.1—0.2 Torr) or more) |

TABLE 1-4
Isotropic etching—Reactive ion
etching and reactive sputter etching

| Material to be etched | Etchant |
|---|---|
| S-Si, Poly Si | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |
| CVD $SiO_2$, TG $SiO_2$ | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |
| $Si_3N_4$ | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |
| PSG | $C_2F_5Cl+CF_4$ (gas pressure 13.3 Pa (0.1 Torr) or more) $CF_4$ or $CF_4+O_2$ (gas pressure of 1.3—2.7 Pa (0.01—0.02 Torr) or more) |

TABLE 2-1
Anisotropic etching—Planar type
plasma etching

| Material to be etched | Etchant |
|---|---|
| $Si_3N_4$, S-Si, Poly Si | $CCl_4$, $PCl_3$, $BCl_3$, $SiCl_4$ other chloride compound gases, above chloride compound gases with $O_2$ or $CF_4$, mixed gases with any of above chloride compound gases, mixed gases with any of above chloride compound gases with $O_2$ or $CF_4$; $CF_6$; $CF_4$ or $CF_4+O_2$(gas pressure below 13.3—26.7 Pa (0.1—0.2 Torr)), $C_2F_5Cl$ or $C_2F_5Cl+CF_4$ (gas pressure 133.3 Pa (1 Torr) or less) |
| PSG, $Si_3N_4$, CVD $SiO_2$, TG $SiO_2$ | $CF_4$ or $CF_4+O_2$ (gas pressure below 13.3—26.7 Pa) (0.1—0.2 Torr)), $CF_4+H_2$, $CHF_3$, $C_2F_6$, $C_3F_8$, $C_4F_8$ |
| Al, Al-Cu Al-Si, Al-Cu-Si | $CCl_4$, $PCl_3$, $BCl_3$, other chloride compound gases, mixed gases with any of above chloride compound gases, mixed gases with any of above chloride compound gases with $O_2$ or $CF_4$, mixed gases with any of above chloride compound gases with inactive gas such as Ar, He, etc. |

TABLE 2-2
Anisotropic etching—Reactive ion
etching and reactive sputter etching

| Material to be etched | Etchant |
|---|---|
| $Si_3N_4$, S-Si, Poly Si | $CCl_4$, $PCl_3$, $BCl_3$, $SiCl_4$ other chloride compound gases, above chloride compound gases with $O_2$ or $CF_4$, mixed gases with any of above chloride compound gases, mixed gases with any of above chloride compound gases with $O_2$ or $CF_4$; $CF_6$; $CF_4$ or $CF_4+O_2$ (gas pressure below 1.3—2.7 Pa (0.01—0.02 Torr)) $C_2F_5Cl$ or $C_2F_5Cl+CF_4$ (gas pressure 13.3 Pa (0.1 Torr) or less) |
| PSG, $Si_3N_4$, CVD $SiO_2$, TG $SiO_2$ | $CF_4$ or $CF_4+O_2$ (gas pressure below 1.3—2.7 Pa (0.01—0.02 Torr)), $CF_4+H_2$, $CHF_3$, $C_2F_6$, $C_3F_8$, $C_4F_8$ |
| Al, Al-Cu Al-Si, Al-Cu-Si | $CCl_4$, $PCl_3$, $BCl_3$, other chloride compound gases, mixed gases with any of above chloride compound gases, mixed gases with any of above chloride compound gases with $O_2$ or $CF_4$, mixed gases with any of above chloride compound gases with inactive gas such as Ar, He, etc. |

5. A method as claimed in claim 1, wherein the anisotropic etching is effected by a dry etching being either planar type plasma etching, reactive sputter etching or reactive ion etching.

6. A method as claimed in claim 5, wherein the isotropic and anisotropic etchings are carried out in one and the same dry etching apparatus, reactive gases employed and/or etching conditions such as amount of gas and gas pressure employed in the apparatus being changed after the isotropic etching to provide for the anisotropic etching.

7. A method as claimed in claim 6, wherein the second layer is of single crystal silicon or of poly crystal silicon or of $Si_3N_4$, and is first etched part way through by isotropic etching using as reactive gas either $CF_4$, or $CF_4+O_2$, or $C_2F_5Cl+CF_4$, and is then etched completely through by anisotropic etching using as reactive gas any of $CCl_4$, $PCl_3$, $BCl_3$, $SiCl_4$, $CF_4$, $CF_4+O_2$, $C_2F_5Cl$, $C_2F_5Cl$ +$CF_4$, or such a chloride compound gas with $O_2$ or $CF_4$, or a mixture of such chloride compound gases, or such a mixture with $O_2$ or $CF_4$, or $SF_6$, or $CF_6$, in one and the same planar type plasma etching apparatus.

8. A method as claimed in claim 6, wherein the second layer is of phospho-silicate glass, or $Si_3N_4$ or silicon dioxide and is first etched part way through by isotropic etching using as reactive gas $C_2F_5Cl+CF_4$, or $CF_4$ or

11

$CF_4+O_2$, and is then etched completely by anisotropic etching using as reactive gas $CF_4$ or $CF_4+H_2$, or $CHF_3$, or $C_2F_6$, or $C_3F_8$, or $C_4F_8$, in one and the same planar type plasma etching apparatus.

9. A method as claimed in claim 5, wherein the second layer is of aluminium or aluminium alloy and is first etched part way through by a wet etching process using a solution of $H_3PO_4$ as etchant, and then etched completely through by anisotropic etching using as reactive gas either $CCl_4$, or $PCl_3$, or $BCl_3$, or a mixture of these, or such a mixture mixed with $O_2$ or $CF_4$, or such a mixture mixed with an inactive gas such as Ar, He in a planar type plasma etching apparatus.

10. A method as claimed in claim 1, in which the second layer is a composite layer comprising two component layers one over the other, the said one component layer having a higher etching rate than the said other component layer.

11. A method as claimed in claim 10 wherein the said one component layer is of $Si_3N_4$ and the said other component layer is of $SiO_2$.

12. A method as claimed in any preceding claim, wherein the first layer is a thin film, for example of photoresist, and the second layer is etched half way through by the isotropic etching.


## Revendications

1. Procédé de fabrication d'un dispositif semiconducteur ayant une structure multicouche, dans lequel on forme une première couche selon un motif prédéterminé sur une seconde couche, cette seconde couche devant être gravée et étant formée au-dessus d'un substrat semiconducteur du dispositif, et on grave la seconde couche en utilisant la première couche comme masque, caractérisé en ce qu'on retire partiellement la seconde couche par gravure isotrope, puis on grave le reste de la seconde couche par gravure anisotrope dans la direction de l'épaisseur de la seconde couche, en utilisant la première couche comme masque, afin d'y former une ouverture, puis on retire la première couche et on forme une troisième couche sur la seconde couche.

2. Procédé selon la revendication 1, où ladite troisième couche est une couche isolante.

3. Procédé selon la revendication 2, où on forme une couche conductrice sur ladite troisième couche.

4. Procédé selon la revendication 1, dans lequel la seconde couche est en un matériau énuméré dans les tableaux 1-1 à 2-2 ci-après, la gravure isotrope utilise un produit d'attaque (et des conditions d'attaque) indiqué comme approprié dans l'un quelconque des tableaux 1-1 à 1-4, et la gravure anisotrope utilise un produit d'attaque (et des conditions d'attaque) indiqué comme approprié pour ce matériau dans l'un des tableaux 2-1 et 2-2.


### Tableau 1-1

### Gravure isotrope - gravure humide

| Matériau à graver | Produit d'attaque |
|---|---|
| S-Si, Poly Si | famille de $HF-HNO_3$ |
| CVD $SiO_2$, TG $SiO_2$ | famille de $HF-H_2O$ |
| PSG | famille de $HF-H_2O$ |
| Al | famille de $H_3PO_4-HNO_3$ |

Tableau 1-2

Gravure isotrope - gravure sous plasma de type en tube

| Matériau à graver | Produit d'attaque |
|---|---|
| S-Si, Poly Si | $CF_4$, $CF_4 + O_2$, $CF_3Cl + O_2$ |
| CVD $SiO_2$, TG $SiO_2$ | $CF_4$, $CF_4 + O_2$, $CF_3Cl + O_2$ |
| $Si_3N_4$ | $CF_4$, $CF_4 + O_2$, $SiF_4$ |
| PSG | $CF_4$, $CF_4 + O_2$, $CClF_3 + O_2$ |

<u>Tableau 1-3</u>

Gravure isotrope - gravure sous plasma de type à plat

| Matériau à graver | Produit d'attaque |
|---|---|
| S-Si, Poly Si | $C_2F_5Cl + CF_4$ (pression de gaz 133,3 Pa (1 Torr) ou plus), $CF_4$ ou $CF_4 + O_2$ (pression de gaz 13,3 - 26,7 Pa (0,1 - 0,2 Torr) ou plus) |
| CVD $SiO_2$, TG $SiO_2$ | $C_2F_5Cl + CF_4$ (pression de gaz 133,3 Pa (1 Torr) ou plus), $CF_4$ ou $CF_4 + O_2$ (pression de gaz 13,3 - 26,7 Pa (0,1 - 0,2 Torr) ou plus) |
| $Si_3N_4$ | $C_2F_5Cl + CF_4$ (pression de gaz 133,3 Pa (1 Torr) ou plus), $CF_4$ ou $CF_4 + O_2$ (pression de gaz 13,3 - 26,7 Pa (0,1 - 0,2 Torr) ou plus) |
| PSG | $C_2F_5Cl + CF_4$ (pression de gaz 133,3 Pa (1 Torr) ou plus), $CF_4$ ou $CF_4 + O_2$ (pression de gaz 13,3 - 26,7 Pa (0,1 - 0,2 Torr) ou plus) |

Tableau 1-4

Gravure isotrope - gravure par pulvérisation réactive
et gravure ionique réactive

| Matériau à graver | Produit d'attaque |
|---|---|
| S-Si, Poly Si | $C_2F_5Cl$ + $CF_4$ (pression de gaz 13,3 Pa (0,1 Torr) ou plus), $CF_4$ ou $CF_4$ + $O_2$ (pression de gaz 1,3 - 2,7 Pa (0,01 - 0,02 Torr) ou plus) |
| CVD $SiO_2$, TG $SiO_2$ | $C_2F_5Cl$ + $CF_4$ (pression de gaz 13,3 Pa (0,1 Torr) ou plus), $CF_4$ ou $CF_4$ + $O_2$ (pression de gaz 1,3 - 2,7 Pa (0,01 - 0,02 Torr) ou plus) |
| $Si_3N_4$ | $C_2F_5Cl$ + $CF_4$ (pression de gaz 13,3 Pa (0,1 Torr) ou plus), $CF_4$ ou $CF_4$ + $O_2$ (pression de gaz 1,3 - 2,7 Pa (0,01 - 0,02 Torr) ou plus) |
| PSG | $C_2F_5Cl$ + $CF_4$ (pression de gaz 13,3 Pa (0,1 Torr) ou plus), $CF_4$ ou $CF_4$ + $O_2$ (pression de gaz 1,3 - 2,7 Pa (0,01 - 0,02 Torr) ou plus) |

Tableau 2-1

Gravure anisotrope - gravure sous plasma de type à plat

| Matériau à graver | Produit d'attaque |
|---|---|
| $Si_3N_4$, S-Si, Poly Si | $CCl_4$, $PCl_3$, $BCl_3$, $SiCl_4$, autres gaz composés de chlorures, gaz composés de chlorures ci-dessus avec $O_2$ ou $CF_4$, gaz mélangés avec l'un quelconque des gaz composés de chlorures ci-dessus, gaz mélangés avec l'un quelconque des gaz composés de chlorures ci-dessus avec $O_2$ ou $CF_4$ ; $CF_6$ ; $CF_4$ ou $CF_4 + O_2$ (pression de gaz en-dessous de 13,3 - 26,7 Pa (0,1 - 0,2 Torr)), $C_2F_5Cl$ ou $C_2F_5Cl + CF_4$ (pression de gaz 133,3 Pa (1 Torr) ou moins) |
| PSG, $Si_3N_4$, CVD $SiO_2$, TG $SiO_2$ | $CF_4$ ou $CF_4 + O_2$ (pression de gaz inférieure à 13,3 - 26,7 Pa (0,1 - 0,2 Torr)) $CF_4 + H_2$, $CHF_3$, $C_2F_6$, $C_3F_8$, $C_4F_8$ |
| Al, Al-Cu Al-Si, Al-Cu-Si | $CCl_4$, $PCl_3$, $BCl_3$, autres gaz composés de chlorures, gaz mélangé avec l'un quelconque des gaz composés de chlorures ci-dessus, gaz mélangé avec l'un quelconque des gaz composés de chlorures ci-dessus avec $O_2$ ou $CF_4$, gaz mélangé avec l'un quelconque des gaz composés de chlorure ci-dessus avec des gaz inactifs tels que Ar, He, etc. |

Tableau 2-2

Gravure anisotrope - gravure ionique réactive

et gravure par pulvérisation réactive

| Matériau à graver | Produit d'attaque |
|---|---|
| $Si_3N_4$, S-Si, Poly Si | $CCl_4$, $PCl_3$, $BCl_3$, $SiCl_4$, autres gaz composés de chlorures, gaz composés de chlorures ci-dessus avec $O_2$ ou $CF_4$, gaz mélangés avec l'un quelconque des gaz composés de chlorures ci-dessus, gaz mélangés avec l'un quelconque des gaz composés de chlorures ci-dessus avec $O_2$ ou $CF_4$ ; $CF_6$ ; $CF_4$ ou $CF_4$ + $O_2$ (pression de gaz en-dessous de 1,3 - 2,7 Pa (0,01 - 0,02 Torr)), $C_2F_5Cl$ ou $C_2F_5Cl$ + $CF_4$ (pression de gaz 13,3 Pa (0,1 Torr) ou moins) |
| PSG, $Si_3N_4$, CVD $SiO_2$, TG $SiO_2$ | $CF_4$ ou $CF_4$ + $O_2$ (pression de gaz inférieure à 1,3 - 2,7 Pa (0,01 - 0,02 Torr)) $CF_4$ + $H_2$, $CHF_3$, $C_2F_6$, $C_3F_8$, $C_4F_8$ |
| Al, Al-Cu, Al-Si, Al-Cu-Si | $CCl_4$, $PCl_3$, $BCl_3$, autres gaz composés de chlorure, gaz mélangé avec l'un quelconque des gaz composés de chlorures ci-dessus, gaz mélangé avec l'un quelconque des gaz composés de chlorures ci-dessus avec $O_2$ ou $CF_4$, gaz mélangé avec l'un quelconque des gaz composés de chlorures ci-dessus avec des gaz inactifs tels que Ar, He, etc. |

5. Procédé selon la revendication 1, dans lequel on effectue la gravure anisotrope par gravure sèche, du

EP 0 030 116 B2

type gravure sous plasma de type à plat, gravure par pulvérisation réactive, ou gravure ionique réactive.

6. Procédé selon la revendication 5, dans lequel on effectue les gravures isotrope et anisotrope dans un seul et même appareil de gravure sèche, les gaz réactifs utilisés et/ou les conditions d'attaque telles que la quantité de gaz et la pression de gaz utilisées dans l'appareil étant modifiés après la gravure isotrope pour permettre la gravure anisotrope.

7. Procédé selon la revendication 6, dans lequel la seconde couche est en silicium monocristallin ou en silicium polycristallin ou en $Si_3N_4$, et on la retire d'abord partiellement par gravure isotrope en utilisant un gaz réactif tel que $CF_4$ ou $CF_4 + O_2$ ou $C_2F_5Cl + CF_4$, puis on la retire complètement par gravure anisotrope en utilisant un gaz réactif tel que $CCl_4$, $PCl_3$, $BCl_3$, $SiCl_4$, $CF_4$, $CF_4 + O_2$, $C_2F_5Cl$, $C_2F_5Cl + CF_4$, ou un tel gaz composé de chlorure avec $O_2$ ou $CF_4$, ou un mélange de tels gaz composés de chlorure, ou un tel mélange avec $O_2$ ou $CF_4$, ou $SF_6$ ou $CF_6$ dans un seul et même appareil de gravure sous plasma de type à plat.

8. Procédé selon la revendication 6, dans lequel la seconde couche est un verre au phosphosilicate, ou $Si_3N_4$, ou du dioxyde de silicium, et on la retire d'abord partiellement par gravure isotrope en utilisant comme gaz réactif $C_2F_5Cl + CF_4$ ou $CF_4$, ou $CF_4 + O_2$, puis on la retire complètement par gravure anisotrope en utilisant comme gaz réactif $CF_4$ ou $CF_4 + H_2$, ou $CHF_3$, ou $C_2F_6$, ou $C_3F_8$, ou $C_4F_8$, dans un seul et même appareil de gravure sous plasma de type à plat.

9. Procédé selon la revendication 5, dans lequel la seconde couche est en aluminium ou en alliage d'aluminium, et on la retire d'abord partiellement par un processus de gravure humide en utilisant une solution de $H_3PO_4$ comme produit d'attaque, puis on la retire ensuite complètement par gravure anisotrope en utilisant comme gaz réactif $CCl_4$ ou $PCl_3$ ou $BCl_3$ ou un mélange de ces gaz ou un tel mélange mélangé à $O_2$ ou $CF_4$, ou un tel mélange mélangé à un gaz inactif tel que Ar, He dans un appareil de gravure sous plasma de type à plat.

10. Procédé selon la revendication 1, dans lequel la seconde couche est une couche composite comprenant deux couches composantes l'une sur l'autre, la première couche composante ayant une vitesse d'attaque plus élevée que l'autre couche composante.

11. Procédé selon la revendication 10, dans lequel la première couche composante est en $Si_3N_4$ et l'autre couche composante est en $SiO_2$.

12. Procédé selon l'une quelconque des revendications précédentes, dans lequel la première couche est une couche mince, par exemple d'un produit photosensible, et on retire la seconde couche à moitié par la gravure isotrope.

## Patentansprüche

1. Verfahren zur Herstellung einer Halbleitervorrichtung mit einer vielschichtigen Struktur, bei dem eine erste Schicht zu einem vorbestimmten Muster geformt wird, über einer zweiten Schicht, welche zweite Schicht geätzt werden soll und über einem Halbleitersubstrat der Vorrichtung geformt wird, und die zweite Schicht durch Verwendung der ersten Schicht als Maske geätzt wird, dadurch gekennzeichnet, daß die zweite Schicht teilweise durch isotropes Ätzen geätzt wird, und dann der Rest der zweiten Schicht- durch anisotropes Ätzen in Richtung der Dicke der zweiten Schicht geätzt wird, unter Verwendung der ersten Schicht als eine Maske, um eine Öffnung durch sie zu bilden, woraufhin die erste Schicht entfernt und eine dritte Schicht auf der zweiten Schicht gebildet wird.

2. Verfahren nach Anspruch 1, bei dem die genannte dritte Schicht eine isolierende Schicht ist.

3. Verfahren nach Anspruch 2, bei dem eine leitende Schicht auf der genannten dritten Schicht gebildet wird.

4. Verfahren nach Anspruch 1, bei dem die zweite Schicht aus einem Material besteht, welches in den folgenden Tabellen 1-1 bis 2-2 aufgelistet ist, und das isotrope Ätzen ein Ätzmittel (und Ätzbedingungen) verwendet, die als geeignet für das Material in einer der Tabellen 1-1 bis 1-4 angegeben sind, und die ' anisotrope Ätzung ein Ätzmittel (und Ätzbedingungen) umfaßt, die als für das Material in irgendeiner der Tabellen 2-1 und 2-2 als geeignet angegeben sind:

Tabelle 1-1

Isotropes Ätzes - Naßätzen

| Zu ätzendes Material | Ätzmittel |
|---|---|
| S-Si, Poly Si | HF-HNO$_3$ Familie |
| CVD SiO$_2$, TG SiO$_2$ | HF-H$_2$O Familie |
| PSG | HF-H$_2$O Familie |
| Al | H$_3$PO$_4$-HNO$_3$ Familie |

Tabelle 1-2

Isotropes Ätzen - Trommeltyp

Plasmaätzen

| zu ätzendes Material | Ätzmittel |
| --- | --- |
| S-Si, Poly Si | $CF_4$, $CF_4 + O_2$, $CF_3Cl + O_2$ |
| CVD $SiO_2$, TG $SiO_2$ | $CF_4$, $CF_4 + O_2$, $CF_3Cl + O_2$ |
| $Si_3N_4$ | $CF_4$, $CF_4 + O_2$, $SiF_4$ |
| PSG | $CF_4$, $CF_4 + O_2$, $CClF_3 + O_2$ |

Tabelle 1-3
Isotropes Ätzen - Planarer Typ
Plasmaätzen

| Zu ätzendes Material | Ätzmittel |
|---|---|
| S-Si, Poly-Si | $C_2F_5Cl$ + $CF_4$ (Gasdruck 133,3 Pa (1 Torr) oder mehr) $CF_4$ oder $CF_4$ + $O_2$ (Gasdruck von 13,3 - 26,7 Pa (0,1 - 0,2 Torr) oder mehr) |
| CVD $SiO_2$, TG $SiO_2$ | $C_2F_5Cl$ + $CF_4$ (Gasdruck 133,3 Pa (1 Torr) oder mehr) $CF_4$ oder $CF_4$ + $O_2$ (Gasdruck von 13,3 - 26,7 Pa (0,1 - 0,2 Torr) oder mehr) |
| $Si_3N_4$ | $C_2F_5Cl$ + $CF_4$ (Gasdruck 133,3 Pa (1 Torr) oder mehr) $CF_4$ oder $CF_4$ + $O_2$ (Gasdruck von 13,3 - 26,7 Pa (0,1 - 0,2 Torr) oder mehr) |
| PSG | $C_2F_5Cl$ + $CF_4$ (Gasdruck 133,3 Pa (1 Torr) oder mehr) $CF_4$ oder $CF_4$ + $O_2$ (Gasdruck von 13,3 - 26,7 Pa (0,1 - 0,2 Torr) oder mehr) |

Tabelle   1-4

Isotropes Ätzen - Reaktives Ionenätzen und

Reaktives Zerstäubungsätzen

| Zu ätzendes Material | Ätzmittel |
|---|---|
| S-Si, Poly-Si | $C_2F_5Cl$ + $CF_4$ (Gasdruck 13,3 Pa (0,1 Torr) oder mehr) $CF_4$ oder $CF_4$ + $O_2$ (Gasdruck von 1,3 - 2,7 Pa (0,01 - 0,02 Torr) oder mehr) |
| CVD $SiO_2$, TG $SiO_2$ | $C_2F_5Cl$ + $CF_4$ (Gasdruck 13,3 Pa (0,1 Torr) oder mehr) $CF_4$ oder $CF_4$ + $O_2$ (Gasdruck von 1,3 - 2,7 Pa (0,01 - 0,02 Torr) oder mehr) |
| $Si_3N_4$ | $C_2F_5Cl$ + $CF_4$ (Gasdruck 13,3 Pa (0,1 Torr) oder mehr) $CF_4$ oder $CF_4$ + $O_2$ (Gasdruck von 1,3 - 2,7 Pa (0,01 - 0,02 Torr) oder mehr) |
| PSG | $C_2F_5Cl$ + $CF_4$ (Gasdruck 13,3 Pa (0,1 Torr) oder mehr) $CF_4$ oder $CF_4$ + $O_2$ (Gasdruck von 1,3 - 2,7 Pa (0,01 - 0,02 Torr) oder mehr) |

Tabelle 2-1

Anisotropes Ätzen - Planarer Typ

Plasmaätzen

---

| Zu ätzendes Material | Ätzmittel |
| --- | --- |
| $Si_3N_4$, S-Si, Poly Si | $CCl_4$, $PCl_3$, $BCl_3$ $SiCl_4$, andere Chloridverbindungsgase, obige Chloridverbindungsgase mit $O_2$ oder $CF_4$, mit einem der obigen Chloridverbindungsgase gemischte Gase, mit einem der obigen Chloridverbindungsgase gemischte Gase mit $O_2$ oder $CF_4$; $CF_6$; $CF_4$ oder $CF_4 + O_2$ (Gasdruck unter 13,3 - 26,7 Pa (0,1 - 0,2 Torr)), $C_2F_5Cl$ oder $C_2F_5Cl$ + $CF_4$ (Gasdruck 133,3 Pa (1 Torr) oder weniger) |

---

| | |
|---|---|
| PSG, $Si_3N_4$,<br>CVD $SiO_2$, TG $SiO_2$ | $CF_4$ oder $CF_4 + O_2$<br>(Gasdruck unter 13,3 - 26,7 Pa (0,1 - 0,2 Torr)),<br>$CF_4 + H_2$, $CHF_3$,<br>$C_2F_6$, $C_3F_8$,<br>$C_4F_8$ |
| Al, Al-Cu<br>Al-Si, Al-Cu-Si | $CCl_4$, $PCl_3$, $BCl_3$, andere Chloridverbindungsgase, mit einem der obigen Chloridverbindungsgase gemischte Gase, mit einem der obigen Chloridverbindungsgase gemischte Gase mit $O_2$ oder $CF_4$, mit einem der obigen Chloridverbindungsgase gemischte Gase mit inaktivem Gas wie Ar, He, etc. |

Tabelle  2-2

Anisotropes Ätzen - Reaktives Ionenätzen und

Reaktives Zerstäubungsätzen

---

Zu ätzendes Material          Ätzmittel

---

Si$_3$N$_4$, S-Si,                    CCl$_4$, PCl$_3$, BCl$_3$, SiCl$_4$

Poly-Si                       andere Chloridverbindungsgase,

obige Chloridverbindungsgase

mit O$_2$ oder CF$_4$, mit einem

der obigen Chloridverbindungs-

gase gemischte Gase, mit einem

der obigen Chloridverbindungs-

gase gemischte Gase mit O$_2$

oder CF$_4$; CF$_6$; CF$_4$ oder

CF$_4$ + O$_2$ (Gasdruck unter

1,3 - 2,7 Pa (0,01 - 0,02

Torr))

C$_2$F$_5$Cl oder

C$_2$F$_5$Cl + CF$_4$ (Gasdruck

13,3 Pa (0,1 Torr) oder

weniger)

---

PSG, Si$_3$N$_4$,                   CF$_4$ oder CF$_4$ + O$_2$

CVD SiO$_2$, TG SiO$_2$            (Gasdruck unter 1,3 - 2,7 Pa

(0,01 - 0,02 Torr)), CF$_4$ +

H$_2$, CHF$_3$, C$_2$F$_6$,

C$_3$F$_8$, C$_4$F$_8$

---

| Al, Al-Cu | $CCl_4$, $PCl_3$, $BCl_3$, |
| Al-Si, Al-Cu-Si | andere Chloridverbindungsgase, mit einem der obigen Chlorid-verbindungsgase gemischte Gase, mit einem der obigen Chlorid-verbindungsgase gemischte Gase mit $O_2$ oder $CF_4$, mit einem der obigen Chloridverbindungs-gase gemischte Gase mit inakti-vem Gas wie Ar, He, etc. |

5. Verfahren nach Anspruch 1, bei dem das anisotrope Ätzen durch ein Trockenätzen bewirkt wird, welches entweder ein Plasmaätzen vom planaren Typ, ein reaktives Zerstäubungsätzen oder reaktives Ionenätzen ist.

6. Verfahren nach Anspruch 5, bei dem die isotropen und anisotropen Ätzungen in ein und derselben Trockenätzvorrichtung durchgeführt werden, und die verwendeten reaktiven.Gase und/oder Ätzbedingungen wie die Menge des Gases und der verwendete Gasdruck in der Apparatur nach dem isotropen Ätzen geändert werden, um das anisotrope Ätzen zu ermöglichen.

7. Verfahren nach Anspruch 6, bei dem die zweite Schicht aus einem einkristallinen Silizium oder aus poly-kristallinem Silizium oder aus $Si_3N_4$ besteht und zunächst teilweise durch isotropes Ätzen geätzt wird, wobei als reaktives Gas entweder $CF_4$, oder $CF_4 + O_2$, oder $C_2F_5Cl + CF_4$ verwendet wird, und dann vollständig durch ein anisotropes Ätzen geätzt wird, unter Verwendung von $CCl_4$, $PCl_3$, $BCl_3$, $SiCl_4$, $CF_4$, $CF_4 + O_2$, $C_2F_5Cl$, $C_2F_5Cl + CF_4$ als reaktives Gas oder solch einem Chlorverbindungsgas mit $O_2$ oder $CF_4$ oder einer Mischung aus solchen Chlorverbindungsgasen, oder solch einer Mischung mit $O_2$ oder $CF_4$, oder $SF_6$, oder $CF_6$ in ein und der-selben Planartyp-Plasmaätzvorrichtung.

8. Verfahren nach Anspruch 6, bei dem die zweite Schicht aus Phosphorsilicatglas oder $Si_3N_4$ oder Sili-ziumdioxid besteht und erst teilweise durch ein isotropes Ätzen geätzt wird, unter Verwendung von $C_2F_5Cl + CF_4$ oder $CF_4$ oder $CF_4 + O_2$ als reaktivem Gas, und dann vollständig durch anisotropes Ätzen geätzt wird, unter Verwendung von $CF_4$ oder $CF_4 + H_2$ oder $CHF_3$ oder $C_2F_6$ oder $C_3F_8$ oder $C_4F_8$ als reaktivem Gas, in ein und derselben Planartyp-Plasmaätzvorrichtung.

9. Verfahren nach Anspruch 5 bei dem die zweite Schicht aus Aluminium oder Aluminiumlegierung besteht und erst teilweise durch ein feuchtes Ätzverfahren unter Verwendung einer Lösung aus $H_3PO_4$ als Ätzmittel geätzt wird, und dann vollständig durch ein anisotropes Ätzen geätzt wird, unter Verwendung von entweder $CCl_4$ oder $PCl_3$-oder $BCl_3$ oder einer Mischung von diesen als reaktivem Gas, oder solch einer Mischung gemischt mit $O_2$ oder $CF_4$, oder solch einer Mischung gemischt mit einem inaktiven Gas wie Ar, He in einer Planartyp-Plasmaätzvorrichtung.

10. Verfahren nach Anspruch 1, bei dem die zweite Schicht eine zusammengesetzte Schicht ist, welche zwei Komponentenschichten, eine über der anderen, umfaßt, wobei die genannte eine Komponentenschicht eine höhere Ätzrate als die andere Komponentenschicht hat.

11. Verfahren nach Anspruch 10, bei dem die genannte eine Komponentenschicht aus $Si_3N_4$ und die genannte andere Komponentenschicht aus $SiO_2$ besteht.

12. Verfahren nach einem der vorhergehenden Ansprüche, bei welchem die erste Schicht ein Dünnfilm ist, z. B. aus Photoresist, und die zweite Schicht halbwegs durch das isotrope Ätzen durchgeätzt wird.

FIG.1

FIG.2

FIG.3

FIG.4

FIG.5

FIG.6

FIG.7

FIG.8

FIG.9

FIG.10

FIG.11

FIG.12